(19) Europäisches Patentamt
European Patent Office
Office européen des brevets

(11) **EP 3 680 102 A1**

(12) **EUROPÄISCHE PATENTANMELDUNG**

(43) Veröffentlichungstag:
**15.07.2020  Patentblatt 2020/29**

(51) Int Cl.:
**B32B 15/01** *(2006.01)*     **B32B 37/02** *(2006.01)*
**B32B 38/00** *(2006.01)*     **G01R 3/00** *(2006.01)*
**H01L 23/00** *(2006.01)*     **B32B 7/05** *(2019.01)*

(21) Anmeldenummer: **19151347.2**

(22) Anmeldetag: **11.01.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Heraeus Deutschland GmbH & Co KG**
**63450 Hanau (DE)**

(72) Erfinder: **DR. FECHER, Jonas**
**63450 Hanau (DE)**

(74) Vertreter: **Schultheiss & Sterzel Patentanwälte PartG mbB**
**Berner Strasse 52**
**60437 Frankfurt am Main (DE)**

(54) **GESCHICHTETE AG/REFRAKTÄRMETALL-FOLIE UND VERFAHREN ZU DEREN HERSTELLUNG**

(57)     Die Erfindung betrifft eine Folie zur Herstellung von Prüfnadeln oder Bonddrähten, die Folie aufweisend eine Dicke von maximal 100 μm und die Folie aufweisend einen Schichtverbund aus Ag-Schichten aus Silber und/oder einer Silber-Basis-Legierung mit zumindest 90 Gew% Silber und Refraktärmetall-Schichten aus einem Refraktärmetall der Gruppe Niob und Tantal oder Refraktärmetall-Schichten aus einer Refraktärmetall-Basis-Legierung mit zumindest 90 Gew% zumindest eines Refraktärmetalls.

Die Erfindung betrifft auch ein Verfahren zur Herstellung eines Schichtverbunds oder einer Folie.

Figur 4

EP 3 680 102 A1

**Beschreibung**

Die Erfindung betrifft eine Folie zur Herstellung von Prüfnadeln oder Bonddrähten sowie ein Verfahren zur deren Herstellung.

Prüfnadeln werden bei der Herstellung von Leistungselektronik, der Kontaktierung von Chips und anderen elektrischen Schaltungen zur Prüfung der Qualität von elektrischen Kontaktierungen eingesetzt (siehe hierzu beispielsweise die US 2014/0266278 A1 und die US 2010/0194415 A1). Aktuell werden für sogenannte "Probe Needles" (Prüfnadeln) Metalle oder Legierungen verwendet, die eine hohe elektrische und thermische Leitfähigkeit aber auch hohe Härten und Zugfestigkeiten besitzen. Dabei dient die elektrische Leitfähigkeit von reinem Kuper (100% IACS) als Referenz. Silber (Ag) kann zu diesen Zwecken jedoch nicht eingesetzt werden da es deutlich zu duktil ist und sich die Nadel beim Einsatz verformen würde. Typische Materialien für Prüfnadeln sind alterungsgehärtete Palladium-Silber-Legierungen, die 10% Gold und 10% Platin enthalten und beispielsweise unter den Produktnamen Paliney®7 und Hera 648 vertrieben werden. Als Materialien für Folien zur Herstellung von Prüfnadeln werden aber auch PtNi-Legierungen oder Rhodium verwendet. Bei solchen Metallen oder Legierungen die einen möglichst guten Kompromiss zwischen elektrischer Leitfähigkeit, thermischer Leitfähigkeit, Zugfestigkeit sowie Härte darstellen, beträgt die maximal mögliche elektrische Leitfähigkeit 5-30% IACS.

Neben Prüfnadeln profitieren aber auch andere Anwendungen, wie insbesondere Bonddrähte, von Materialien mit hohen elektrischen und thermischen Leitfähigkeiten und gleichzeitig guten mechanische Eigenschaften, wie einer hohen Härte und Zugfestigkeit.

Anwendungen wie Prüfnadeln (Probe Needles) oder Bondbänder (Bonddrähte) in der Leistungselektronik erfordern neben einer hohen elektrischen Leitfähigkeit auch eine hohe mechanische Festigkeit und Härte. Dabei ist auch die Temperaturbeständigkeit beziehungsweise die Warmfestigkeit von entscheidender Bedeutung. Hierzu werden derzeit ausscheidungsgehärtete Kupfer-Legierungen (Cu-Legierungen) verwendet, welche durch Kokillenguss, Lösungsglühen, Ausscheidungswärmebehandlung und Walzen zu dünnen Bändern mit einer Dicke von weniger als 54 $\mu$m verarbeitet werden.

Durch die Ausscheidungshärtung sind ausscheidungsgehärtete Cu-Legierungen, insbesondere durch die in der Anwendung auftretende mechanische Belastung nur bedingt warmfest. Das heißt, dass sie bei erhöhter Temperatur erweichen und ihre Funktion nicht mehr erfüllen können. Insbesondere bei sehr dünnen Prüfnadeln kann es durch die dadurch auftretenden hohen Stromstärkedichten bei gleichzeitig geringem Querschnitt zur Wärmeableitung zu einer erheblichen Erwärmung der Prüfnadeln im Einsatz kommen. Auch bei den erwärmten Prüfnadeln darf es nicht zu einer Veränderung während der Messung und der elektrischen Kontaktierung durch die Prüfnadeln aufgrund von zu starken Änderungen der elektrischen und mechanischen Eigenschaften der Prüfnadeln kommen. Deshalb werden derzeit insbesondere für dünne Prüfnadeln warmfestere, vorzugsweise mischkristallhärtende Legierungen wie zum Beispiel aus Cu und Be verwendet, die aber eine wesentlich schlechtere elektrische Leitfähigkeit aufweisen als ausscheidungsgehärtete Cu-Legierungen.

Die WO 2016/009293 A1 schlägt eine Prüfnadel vor, bei der eine Prüfnadel an deren Spitze aus einem mechanisch harten ersten Material besteht und dessen Rest aus einem zweiten Material mit einer hohen elektrischen Leitfähigkeit besteht. Ähnliche Prüfnadeln sind auch aus der US 2013/0099813 A1, der EP 2 060 921 A1 und der US 2012/0286816 A1 bekannt. Nachteilig ist hieran, dass die Prüfnadel über ihre Länge keine homogenen physikalischen Eigenschaften mehr hat und dass die elektrische und thermische Leitfähigkeit aber auch die Zugfestigkeit sehr stark von der Verbindung zwischen den beiden Materialien abhängt. Zudem lässt sich eine niedrige elektrische Leitfähigkeit in einem Bereich nicht einfach durch eine hohe elektrische Leitfähigkeit in einem anderen Bereich ausgleichen, da der Strom beide Bereiche passieren muss.

Die Aufgabe der Erfindung besteht darin, die Nachteile des Stands der Technik zu überwinden. Insbesondere soll eine Folie gefunden werden und ein Verfahren zur Herstellung einer Folie gefunden werden, aus der beziehungsweise mit dem Prüfnadeln oder Bonddrähte mit hoher elektrischer Leitfähigkeit bei gleichzeitig guten mechanischen Eigenschaften, wie einer hohen Härte, Warmfestigkeit und Zugfestigkeit auf einfach Weise herstellbar sind.

Beschichtungsverfahren sind zur Herstellung solcher Folien ungeeignet, da sich die Beschichtungen nicht ohne weiteres vom Substrat lösen lassen und die physikalischen Eigenschaften eines beschichteten Substrats nicht denen der Beschichtung entsprechen. Gleichzeitig ist es sehr aufwendig, Beschichtungen mit der notwendigen Dicke zu erzeugen.

Die Aufgaben der Erfindung werden gelöst durch eine Folie zur Herstellung von Prüfnadeln oder Bonddrähten, die Folie aufweisend eine Dicke von maximal 100 $\mu$m und die Folie aufweisend einen Schichtverbund aus

Ag-Schichten aus Silber und/oder einer Silber-Basis-Legierung mit zumindest 90 Gew% Silber und

Refraktärmetall-Schichten aus einem Refraktärmetall der Gruppe Niob und Tantal oder Refraktärmetall-Schichten aus einer Refraktärmetall-Basis-Legierung mit zumindest 90 Gew% zumindest eines Refraktärmetalls aus der Gruppe Niob, Tantal, Vanadium, Wolfram, Molybdän und Chrom.

Theoretisch können als Refraktärmetall-Schichten alle Refraktärmetalle der 4., 5. und 6. Nebengruppe verwendet werden, also Titan (Ti), Zirconium (Zr), Hafnuim (Hf), Vanadium (V), Niob, (Nb), Tantal (Ta), Chrom (Cr), Molybdän (Mo) und Wolfram (W). Niob und Tantal werden jedoch besonders bevorzugt, wobei Niob gegenüber Tantal bevorzugt wird. Als Refraktärmetall-Basis-Legierung werden, dementsprechend Nb-Basis-Legierungen mit zumindest 90 Gew% Niob, Ta-Basis-Legierungen mit zumindest 90 Gew% Tantal und NbTa-Basis-Legierungen mit zumindest 90 Gew% NbTa bevorzugt.

Die zu der Folie aber auch zu dem erfindungsgemäßen Verfahren angegebenen Metalle Silber (Ag), Niob (Nb), Tantal (Ta), Vanadium (V), Molybdän (Mo) und Wolfram (W) können auf übliche Weise dargestellt werden. Es kann sein, dass das Ag sowie das Nb, das Ta, das V, das Mo und/oder das W sich einschließlich üblicher Verunreinigungen verstehen, insbesondere einschließlich erschmelzungsbedingter Verunreinigungen. Derartige Verunreinigungen ergeben sich aus dem Herstellungsprozess und liegen üblicherweise bei einem Anteil von höchstens 1 Gew% oder weniger, vorzugsweise bei einem Anteil von höchstens 0,1 Gew% oder weniger.

Als Ag-Schicht kann Ag einschließlich erschmelzungsbedingter Verunreinigungen oder eine Ag-Basis-Legierung mit zumindest 90 Gew% Ag einschließlich erschmelzungsbedingter Verunreinigungen verwendet werden.

Als Refraktärmetall-Schichten können Nb-Schichten aus Nb einschließlich erschmelzungsbedingter Verunreinigungen oder aus einer Nb-Basis-Legierung mit zumindest 90 Gew% Nb einschließlich erschmelzungsbedingter Verunreinigungen verwendet werden.

Als Refraktärmetall-Schichten können Ta-Schichten aus Ta einschließlich erschmelzungsbedingter Verunreinigungen oder aus einer Ta-Basis-Legierung mit zumindest 90 Gew% Ta einschließlich erschmelzungsbedingter Verunreinigungen verwendet werden.

Als Refraktärmetall-Schichten können auch NbTa-Legierungen mit zumindest 90 Gew% NbTa einschließlich erschmelzungsbedingter Verunreinigungen verwendet werden.

Es kann bevorzugt vorgesehen sein, dass das Silber oder die Silber-Basis-Legierung weniger als 20 ppm (parts per million) Schwefel, weniger als 10 ppm Eisen und weniger als 10 ppm Nickel enthält.

Es kann bevorzugt auch vorgesehen sein, dass das Refraktärmetall oder die Refraktärmetall-Basis-Legierung weniger als 50 ppm Eisen, weniger als 50 ppm Nickel enthält und jeweils weniger als 10 ppm von chemischen Elementen enthält, die keine Refraktärmetalle sind.

Es kann bevorzugt auch vorgesehen sein, dass das Niob oder die Niob-Basis-Legierung weniger als 50 ppm Kohlenstoff, weniger als 50 ppm Sauerstoff, weniger als 50 ppm Stickstoff, weniger als 50 ppm Eisen, weniger als 50 ppm Nickel und bis zu 200 ppm Tantal enthält.

Es kann bevorzugt auch vorgesehen sein, dass das Tantal oder die Tantal-Basis-Legierung weniger als 50 ppm Kohlenstoff, weniger als 50 ppm Sauerstoff, weniger als 50 ppm Stickstoff, weniger als 50 ppm Eisen, weniger als 50 ppm Nickel und bis zu 200 ppm Niob enthält.

hält.

Es kann bevorzugt ferner vorgesehen sein, dass die Tantal-Niob-Legierung weniger als 50 ppm Kohlenstoff, weniger als 50 ppm Sauerstoff, weniger als 50 ppm Stickstoff, weniger als 50 ppm Eisen und weniger als 50 ppm Nickel enthält.

Weitere Verunreinigungen außer den hier angegebenen können unterhalb von 5 ppm liegen, vorzugsweise unterhalb von 1 ppm.

Die Ag-Schichten sowie die Refraktärmetall-Schichten liegen vorzugsweise schichtförmig in einer Ebene senkrecht zur Dicke der Folie vor (also parallel zur Folienebene).

Besonders bevorzugt sind die Ag-Schichten und die Refraktärmetall-Schichten miteinander kaltverschweißt.

Prüfnadeln dienen dazu, das Vorhandensein einer elektrischen Kontaktierung durch Messung der elektrischen Leitfähigkeit zu bestimmen. Prüfnadeln werden auch als "probe-needles" bezeichnet und sind dem Fachmann unter diesem Fachbegriff bekannt.

Bonddrähte, die auch als Bondbändchen bezeichnet werden können, dienen der elektrischen Kontaktierung von Chips mit integrierten Schaltungen.

Die Refraktärmetall-Schichten können nicht durchgehend sein und können auch räumlich begrenzte Inseln innerhalb der Folie bilden. Auch die Ag-Schichten können Löcher und Bereiche mit Durchbrechungen aufweisen. Es wird jedoch erfindungsgemäß bevorzugt, wenn die Refraktärmetall-Schichten und auch die Ag-Schichten durchgehend sind.

Unter einer Schicht (Ag-Schicht, Refraktärmetall-Schicht, Nb-Schicht, Ta-Schicht, NbTa-Schicht) wird im Sinne der vorliegenden Patentanmeldung aber nicht nur eine durchgehende Fläche verstanden, sondern auch eine mit Durchbrechungen und im Falle der Refraktärmetall-Schichten auch eine in Form von mehreren lokalen flachen Einschlüssen vorliegende Schicht. Die flachen Einschlüsse können dabei bezogen auf eine Richtung parallel zur Dicke der Folie flach sein.

Bevorzugt kann vorgesehen sein, dass die Folie eine Dicke von maximal 50 $\mu$m aufweist. Bei einer Folie mit dieser Dicke können dünne Prüfnadeln und Bonddrähte direkt aus der Folie geschnitten oder gestanzt werden.

Es kann vorgesehen sein, dass der Schichtverbund zumindest 4 Ag-Schichten und 4 Refraktärmetall-Schichten pro 10 $\mu$m Dicke aufweist.

Hierdurch ist sichergestellt, dass die eine Härtung des Schichtverbunds durch die abwechselnden Ag-Schichten und Refraktärmetall-Schichten erfolgt.

Es kann bevorzugt vorgesehen sein, dass die Folie zumindest 8 Ag-Schichten und 8 Refraktärmetall-Schichten pro 10 $\mu$m Dicke aufweist, besonders bevorzugt zumindest 16 Ag-Schichten und 16 Refraktärmetall-Schichten pro 10 $\mu$m Dicke aufweist, ganz besonders bevorzugt zumindest 32 Ag-Schichten und 32 Refraktärmetall-Schichten pro 10 $\mu$m Dicke aufweist. Bei diesen Dicken ergibt sich jeweils eine weitere Verbesserung der mechanischen Eigenschaften der Folie, ohne dass die gewünschte elektrische Leitfähigkeit darunter leidet.

Bevorzugt kann vorgesehen sein, dass die Folie aus dem Schichtverbund besteht. Die Folie hat dann keine weiteren Bestandteile außer den Ag-Schichten und den Refraktärmetall-Schichten.

Die Folie ist bevorzugt eine Metallfolie. Die Folie kann auch eine beschichtete Metallfolie sein.

Bei erfindungsgemäßen Folien kann vorgesehen sein, dass die Refraktärmetall-Schichten Nb-Schichten sind, die aus Niob oder einer Nb-Basis-Legierung mit zumindest 90 Gew% Niob bestehen, oder die Refraktärmetall-Schichten Ta-Schichten sind, die aus Tantal oder einer Ta-Basis-Legierung mit zumindest 90 Gew% Tantal bestehen, oder die Refraktärmetall-Schichten NbTa-Schichten sind, die aus einer NbTa-Legierung mit zumindest 90 Gew% NbTa bestehen.

Mit diesen Refraktärmetall-Schichten ergeben sich besonders harte und wärmeharte Folien, die gut als Prüfnadeln aber auch als Bonddrähte einsetzbar sind.

Ferner kann vorgesehen sein, dass die Ag-Schichten in einer Richtung parallel zur Dicke der Folie miteinander verbunden sind, insbesondere kaltverschweißt sind, oder aneinander angrenzen, wobei vorzugsweise die Ag-Schichten eine zusammenhängende Matrix bilden, in der die Refraktärmetall-Schichten angeordnet sind, wobei besonders bevorzugt die Ag-Schichten auch in der Richtung parallel zur Dicke der Folie eine zusammenhängende Matrix bilden.

Hierdurch wird erreicht, dass die Folie eine hohe elektrische Leitfähigkeit hat und gleichzeitig durch die Refraktärmetall-Schichten mechanisch stabilisiert und gehärtet ist. Diese Mischung aus der vom Silber herrührenden hohen elektrischen Leitfähigkeit und der durch die eingeschlossenen Refraktärmetall-Schichten erreichten hohen Härte und Wärmefestigkeit, also der Härte der Folie und aus der Folie hergestellter Prüfnadeln und Bonddrähte auch bei erhöhten Temperaturen von bis zu 200 °C, macht die Folie insbesondere für Prüfnadeln aber auch für Bonddrähte gut einsetzbar. Die Richtung parallel zur Dicke der Folie ist vorzugsweise senkrecht zu den Ag-Schichten ausgerichtet.

Des Weiteren kann vorgesehen sein, dass die Folie eine elektrische Leitfähigkeit von zumindest $10 * 10^6$ A/(V m) in einer Ebene senkrecht zur Dicke der Folie aufweist, bevorzugt eine elektrische Leitfähigkeit von zumindest $30 * 10^6$ A/(V m) in der Ebene senkrecht zur Dicke der Folie aufweist, besonders bevorzugt eine elektrische Leitfähigkeit von zumindest $40 * 10^6$ A/(V m) in der Ebene senkrecht zur Dicke der Folie aufweist.

Hierdurch ist die Folie aufgrund ihrer hohen elektrischen Leitfähigkeit bei gleichzeitig hoher Härte und Wärmefestigkeit gut zur Herstellung von Prüfnadeln oder zur Herstellung von Bonddrähten geeignet.

Bevorzugt ist die elektrische Leitfähigkeit in der Richtung parallel zur Dicke der Folie um mindestens 50% geringer als in der Ebene senkrecht zur Dicke der Folie, bevorzugt maximal halb so groß wir in der Ebene in der Ebene senkrecht zur Dicke der Folie der Folie.

Zur Messung wird eine Vierpunkt-Messmethode verwendet. Die Vierpunkt-Messmethode, auch Vierpunktmessung oder Vierspitzenmessung, ist ein Verfahren, um den Flächenwiderstand, also den elektrischen Widerstand einer Oberfläche oder dünnen Schicht, zu ermitteln. Bei dem Verfahren werden vier Messspitzen in einer Reihe auf die Oberfläche der Folie gebracht, wobei über die beiden Äußeren ein bekannter Strom fließt und mit den beiden Inneren der Potentialunterschied, das heißt, die elektrische Spannung zwischen diesen Spitzen, gemessen wird. Da das Verfahren auf dem Prinzip der Vierleitermessung beruht, ist es weitgehend unabhängig vom Übergangswiderstand zwischen den Messspitzen und der Oberfläche (Prinzip Thomson-Brücke). Benachbarte Messspitzen haben jeweils den gleichen Abstand. Der Flächenwiderstand $R$ ergibt sich aus der gemessenen Spannung $U$ und dem Strom $I$ nach der Formel:

$$R = \frac{\pi}{\ln 2} \frac{U}{I}$$

Um aus dem Flächenwiderstand $R$ den spezifischen Widerstand $\rho$ des Schichtmaterials zu errechnen, multipliziert man ihn mit der Dicke $d$ (Schichtdicke) der Folie:

$$\rho = d R$$

Die elektrische Leitfähigkeit ergibt sich aus dem Kehrwert des spezifischen Widerstands.

Es kann vorgesehen sein, dass die Folie eine Nanoindentierungs-Härte von zumindest 4 GPa in einer Ebene senkrecht zur Dicke der Folie aufweist, vorzugsweise eine Härte von zumindest 5 GPa in der Ebene senkrecht zur Dicke der Folie aufweist.

Die angegebene Härte bezieht sich dabei auf Raumtemperatur (25 °C). Zur Messung wurde ein Nanoindenter mit einer Kontinuierlichen-Steifigkeits-Messungs-Einheit (CSM "continuous stiffness measurement testing unit") verwendet, mit der eine kontinuierliche Auswertung der Härte bei Temperaturen bis 1000 °C möglich ist. Hierzu wurde eine kontinuierlich ansteigende Kraft mit einer Spitze von 120 mN und einer Toleranz von $\pm$ 50 mN verwendet. Als Indentierungsspitze wurde eine Wolframcarbid-Spitze nach Berkovich ein sogenannter "Berkovich indenter" verwendet. Die Nanoindentierungs-Messungen erfolgten gemäß W. C. Oliver, G. M. Pharr, Journal of Materials Research, 1992, 1564 mit den zuvor angegebenen Parametern und einem Aufbau, wie er aus J.M. Wheeler, et al. Curr Opin Solid St M 19 (2015) 354-366 bekannt ist.

Es kann auch vorgesehen sein, dass der Schichtverbund als Zwischenprodukt zur Herstellung der Folie eine Vickers-Härte HV10 von zumindest 100 in einer Richtung senkrecht zur Schichtverbundebene aufweist, vorzugsweise eine Vickers-Härte HV10 von zumindest 110 in einer Richtung senkrecht zur Schichtverbundebene aufweist.

Die Vickers-Härte HV10 wird dabei mit einer Kraft von 10 N in Richtung der Dicke der Folie gemessen. Die Messung der Vickers-Härte erfolgt gemäß DIN EN ISO 6507-1:2018 bis -4:2018: DIN Deutsches Institut für Normung e.V.: Metallische Werkstoffe - Härteprüfung nach Vickers - Teil 1: Prüfverfahren.

Bei dieser Härte kann eine aus der Folie gefertigte Prüfnadel mehrfach zur Messung einer Kontaktierung verwendet werden, ohne dass sich diese zu stark verformt oder abnutzt.

Gemäß einer bevorzugten Weiterbildung der vorliegenden Erfindung kann vorgesehen sein, dass die maximalen Schichtdicken der Ag-Schichten und/oder die maximalen Schichtdicken der Refraktärmetall-Schichten kleiner als 5 μm sind, vorzugsweise kleiner als 1 μm sind.

Hierdurch wird eine ausreichende Härtung der Folie sichergestellt.

Unter einer maximalen Schichtdicke wird vorliegend die maximale lokale Schichtdicke verstanden. Es kann sein und ist insbesondere bei sehr dünnen Schichtdicken so, dass lokal erheblich größere Dicken der Schichten erreicht werden als eine über die gesamte Fläche senkrecht zur Dicke der Folie gemittelte Schichtdicke. Die Schichtdicken können anhand von Querschliffen der Folie mit dem Rasterelektronenmikroskop (REM) bestimmt werden.

Auch die gemittelten Schichtdicken können durch die Herstellung (wie beispielsweise das Falten) geringfügig unterschiedlich groß werden und dabei in beschränktem Rahmen variieren.

Des Weiteren kann vorgesehen sein, dass der Anteil der Refraktärmetall-Schichten in dem gesamten Schichtverbund der Folie zwischen 3 Gew% und 30 Gew% liegt, bevorzugt zwischen 5 Gew% und 25 Gew%, besonders bevorzugt zwischen 15 Gew% und 20 Gew%.

Der Rest der Masse des Schichtverbunds der Folie entfällt vorzugsweise auf die Ag-Schichten.

Hierdurch kann eine Silber-Matrix oder eine Silber-Basis-Legierungs-Matrix bereitgestellt werden, die eine hohe elektrische Leitfähigkeit garantiert und gleichzeitig eine hohe mechanische Festigkeit durch eine hierfür ausreichende Menge an Refraktärmetall-Schichten erreicht werden.

Ferner kann vorgesehen sein, dass die Ag-Schichten aus einer Silber-Basis-Legierung mit einem Kupfer-Gehalt zwischen 0,1 Gew% und 1 Gew% bestehen, vorzugsweise aus einer Silber-Basis-Legierung mit 0,4 Gew% Cu oder einer Silber-Basis-Legierung mit 0,8 Gew% Cu bestehen.

Der Rest der Silber-Basis-Legierung mit 0,4 Gew% Cu beziehungsweise der Silber-Basis-Legierung mit 0,8 Gew% Cu ist jeweils Silber. Zusätzlich sind selbstverständlich noch übliche Verunreinigungen vorhanden.

Mit diesem Silber-Gehalt ergibt sich eine hohe elektrische Leitfähigkeit bei gleichzeitig erhöhter mechanischer Härte der Ag-Schichten.

Gemäß einer Weiterbildung kann vorgesehen sein, dass die Refraktärmetall-Schichten teilweise lokal begrenzte Einschlüsse zwischen den Ag-Schichten bilden, wobei vorzugsweise die Einschlüsse sich in einer Breiten-Richtung senkrecht zur Dicke der Folie zwischen 10 μm und 1000 μm erstrecken und in einer Dicken-Richtung parallel zur Dicke der Folie zwischen 50 nm und 20 μm erstrecken und/oder wobei vorzugsweise die Einschlüsse in der Breiten-Richtung senkrecht zur Dicke der Folie zumindest doppelt so groß sind, insbesondere zumindest fünfmal so groß sind, wie in der Dicken-Richtung parallel zur Dicke der Folie.

Hierdurch wird eine hohe mechanische Härtung der Folie erreicht, ohne dabei die elektrische Leitfähigkeit der Ag-Schicht wesentlich zu verringern.

Bevorzugt kann auch vorgesehen sein, dass die Folie eine Dicke von mindestens 1 μm aufweist, bevorzugt eine Dicke von mindestens 5 μm aufweist, ganz besonders bevorzugt von zumindest 10 μm aufweist.

Hierdurch wird sichergestellt, dass insbesondere aus der Folie hergestellten Prüfnadeln aber auch aus der Folie hergestellten Bonddrähte eine ausreichende Dicke haben, damit keine zu großen Stromdichten in den Prüfnadeln und Bonddrähten auftreten. Hierdurch wird eine zu große Temperaturerhöhung der Prüfnadeln und Bonddrähte bei Stromleitung vermieden. Dünnere Folien sind mit Kaltwalzverfahren nur mit erheblichem zusätzlichem Aufwand zu fertigen. Zudem sind dünnere Folien nicht mehr kostengünstig weiterverarbeitbar.

Die der vorliegenden Erfindung zugrundeliegenden Aufgaben werden auch gelöst durch ein Verfahren zur Herstellung eines Schichtverbunds oder einer Folie zur Herstellung von Prüfnadeln oder Bonddrähten, gekennzeichnet durch die Schritte:

1) Bereitstellen eines ersten Blechs aus Silber oder aus einer Silber-Basis-Legierung mit zumindest 90 Gew% Silber oder zweier erster Bleche aus Silber und/oder aus einer Silber-Basis-Legierung mit zumindest 90 Gew% Silber,

2) Bereitstellen eines zweiten Blechs aus Niob oder aus einer Niob-Basis-Legierung mit zumindest 90 Gew% Niob oder aus Tantal oder aus einer Tantal-Basis-Legierung mit zumindest 90 Gew% Tantal oder aus einer Refraktärmetall-Legierung mit zumindest 90 Gew% zumindest eines Refraktärmetalls aus der Gruppe Niob, Tantal, Vanadium, Wolfram, Molybdän und Chrom;

3) Übereinanderlegen des ersten Blechs und des zweiten Blechs oder Legen des zweiten Blechs zwischen die zwei ersten Bleche;

4) anschließendes Kaltwalzen des ersten Blechs und des zweiten Blechs oder der zwei ersten Bleche und des zweiten Blechs, so dass diese miteinander kaltverschweißen und einen Schichtverbund bilden; und

5) Falten des Schichtverbunds durch Trennen des Schichtverbunds, Übereinanderlegen der Teile des Schichtverbunds und Kaltwalzen der übereinandergelegten Teile des Schichtverbunds oder durch Knicken des Schichtverbunds, Übereinanderlegen der abgeknickten Teile des Schichtverbunds und Kaltwalzen der übereinandergelegten Teile des Schichtverbunds, wobei das Falten zumindest dreimal wiederholt wird, um einen mehrfach gefalteten Schichtverbund zu erhalten.

Unter einem Falten wird im Rahmen der vorliegenden Erfindung also auch ein Verfahrensschritt verstanden, bei dem der Schichtverbund in Teile geschnitten wird und die auseinandergeschnittenen Teile übereinandergelegt werden, um diese anschließend zu walzen.

Dabei kann vorgesehen sein, dass mit dem Verfahren eine erfindungsgemäße Folie hergestellt wird.

Hierdurch ergeben sich für das Verfahren die gleichen Vorteile wie für die Folie.

Es kann vorgesehen sein, dass bei dem Verfahren ein Walzen des mehrfach gefalteten Schichtverbunds auf eine Dicke von maximal 100 μm erfolgt.

Dies ist nur dann notwendig, wenn der mehrfach gefaltete Schichtverbund eine größere Dicke aufweist. Hiermit wird eine Folie bereitgestellt, die direkt zur Herstellung von Bondbändchen beziehungsweise Bonddrähten oder zur Herstellung von Prüfnadeln verwendet werden kann. Die Bonddrähte beziehungsweise die Prüfnadeln können dann direkt aus der Folie ausgeschnitten werden.

Ferner kann vorgesehen sein, dass vor dem Übereinanderlegen des ersten Blechs und des zweiten Blechs zumindest die zum kaltverschweißen vorgesehenen Oberflächen des ersten Blechs und/oder des zweiten Blechs aufgeraut werden, insbesondere durch Bürsten aufgeraut werden, oder vor dem Legen des zweiten Blechs zwischen die zwei ersten Bleche zumindest die zum kaltverschweißen vorgesehenen Oberflächen des ersten Blechs und/oder des zweiten Blechs aufgeraut werden, insbesondere durch Bürsten aufgeraut werden, wobei vorzugsweise alle zum kaltverschweißen vorgesehenen Oberflächen des ersten Blechs oder der zwei ersten Bleche und/oder des zweiten Blechs aufgeraut werden, besonders bevorzugt durch Bürsten mit einer Metallbürste aufgeraut werden.

Hierdurch kann der Schichtverbund miteinander verzahnt werden, so dass sich die Schichten besser miteinander verbinden und weniger stark dazu neigen, sich innerhalb einer Ebene senkrecht zur Dicke der Folie zu separieren und dadurch zu dicke Einschlüsse bezüglich der Dicke der zu erzeugenden Folie zu bilden.

Die der vorliegenden Erfindung zugrundeliegenden Aufgaben werden auch gelöst durch eine Folie erhältlich mit einem solchen Verfahren.

Die der vorliegenden Erfindung zugrundeliegenden Aufgaben werden ferner gelöst durch eine Prüfnadel zur Messung einer elektrischen Kontaktierung hergestellt aus einer erfindungsgemäßen Folie oder mit einem solchen Verfahren, wobei die Prüfnadel eine Dicke zwischen 2 μm und 100 μm aufweist.

Die Prüfnadel kann an ihrer Oberfläche mit einem Metall beschichtet sein. Bevorzugt kann die Prüfnadel an ihrer Oberfläche mit Gold, Platin, Palladium oder einer Basislegierung mit wenigstens einem dieser Elemente beschichtet sein.

Die der vorliegenden Erfindung zugrundeliegenden Aufgaben werden schließlich auch gelöst durch einen Bonddraht zur elektrischen Kontaktierung eines Chips hergestellt aus einer erfindungsgemäßen Folie oder mit einem solchen Verfahren, wobei der Bonddraht einen Querschnitt zwischen 2 μm und 100 μm aufweist.

Der Erfindung liegt die überraschende Erkenntnis zugrunde, dass es durch eine 100 μm dicke Folie aufweisend einen Schichtverbund von mehreren dünnen Ag-Schichten und mehreren dünnen Refraktärmetall-Schichten gelingt, ein Material bereitzustellen, aus dem auf einfache Weise Prüfnadeln oder Bonddrähte geschnitten oder gestanzt werden können, die in entlang ihrer Länge eine hohe elektrische Leitfähigkeit aufweisen, die vom Silber resultiert, gleichzeitig aber auch eine große Härte und Wärmefestigkeit aufweisen, die von den beim Verbinden der Ag-Schichten und Refraktärmetall-Schichten entstehenden Anteilen des Refraktärmetalls oder der Refraktärmetalle zwischen den Ag-Schichten resultiert. Durch Kaltwalzen und Falten der Ausgangsmaterialien Silber und Refraktärmetall miteinander wird eine stabile Verbindung erzeugt, die mechanisch gut für den Einsatz als Prüfnadel und als Bonddraht beziehungsweise Bondbändchen geeignet ist.

Gegenstand der Erfindung sind laminierte Metallschichtverbunde mit Silber als einem Teil des Verbunds. Zudem enthält der Verbund weitere Materialien in Form von Refraktärmetallen, wie z. B. Nb, W, Cr, Ta oder Mo, die mit Silber nicht mischbar sind. Übereinander liegende Bleche (zum Beispiel Ag-Nb-Ag) können so miteinander verwalzt werden, dass sie kaltverschweißen und einen laminierten Schichtverbund in Form eines Blechs bilden. Dieses wird geteilt, übereinandergelegt und wieder miteinander verwalzt. Bei jedem dieser Walzschritte verdoppelt sich die Lagenanzahl und die Anzahl der Grenzflächen (Ag-Nb im Beispiel). Bei Lagenanzahlen von zumindest 500 Ag-Schichten und Refraktärmetall-Schichten, beziehungsweise Lagendicken von kleiner 20 μm tritt neben der Kaltverfestigung ein zusätzlicher Härtungseffekt durch die Grenzflächen beziehungsweise die geringe Lagendicke auf. Diese Härtungseffekt wird bei gleichzeitig hoher elektrischer Leitfähigkeit erfindungsgemäß genutzt. Die erfindungsgemäße Folie ist somit zur Herstellung von Prüfnadeln oder Leitungswerkstoffen, wie Bonddrähten, in der Elektronik vorteilhaft. Da Silber und beispielsweise Niob nicht mischbar sind, bleibt die hohe elektrische Leitfähigkeit des Silbers im Gegensatz zu Mischkristallgehärteten Legierungen erhalten.

Silberweißt mit ca. 61,3 M S/m eine höhere elektrische Leitfähigkeit als Kupfer auf (ca. 58,1 M S/m), was für eine Anwendung in der Kontakttechnik und Elektronik vorteilhaft ist.

Die über Walzen hergestellten Metall-Schichtverbunde ermöglichen eine Kombination einer hohen elektrischen Leitfähigkeit mit einer hohen mechanischen Festigkeit, die auch bei erhöhter Temperatur erhalten bleibt (hohe Warmfestigkeit).

Das verwendet Verfahren (auch "accumulative roll bonding", kurz ARB genannt) und der dabei auftretende Härtungseffekt war für die Anwendung des Verfahrens zur Herstellung hoch leitfähiger Materialien aus Silber und einem Refraktärmetall nicht bekannt.

Neben Silber und Niob sind für die Herstellung der Folie alle Legierungen denkbar und interessant die keinen Mischkristall bilden, wie zum Beispiel Cu mit Mo, Ta, W, Cr.

Im Folgenden werden Ausführungsbeispiele der Erfindung anhand von sieben Figuren erläutert, ohne jedoch dabei die Erfindung zu beschränken. Dabei zeigt:

Figur 1: eine Aufnahme mit einem Raster-Elektronen-Mikroskop (REM) eines Querschliffs durch einen 2-fach gefalteten kaltgewalzten Ag-Nb-Schichtverbund als erfindungsgemäße Folie;

Figur 2: eine Aufnahme mit einem REM eines Querschliffs durch einen 3-fach gefalteten kaltgewalzten Ag-Nb-Schichtverbund als erfindungsgemäße Folie;

Figur 3: eine Aufnahme mit einem REM eines Querschliffs durch einen 4-fach gefalteten kaltgewalzten Ag-Nb-Schichtverbund als erfindungsgemäße Folie;

Figur 4: eine Aufnahme mit einem REM eines Querschliffs durch einen 5-fach gefalteten kaltgewalzten Ag-Nb-Schichtverbund als erfindungsgemäßen Folie;

Figur 5: eine Aufnahme mit einem REM eines Querschliffs durch einen 6-fach gefalteten kaltgewalzten Ag-Nb-Schichtverbund als erfindungsgemäße Folie;

Figur 6: eine Aufnahme mit einem REM eines Querschliffs durch einen 7-fach gefalteten kaltgewalzten Ag-Nb-Schichtverbund als erfindungsgemäße Folie; und

Figur 7: ein Diagramm der Vickers-Härte gegen die elektrische Leitfähigkeit mit Messwerten verschiedener erfindungsgemäßer Folien.

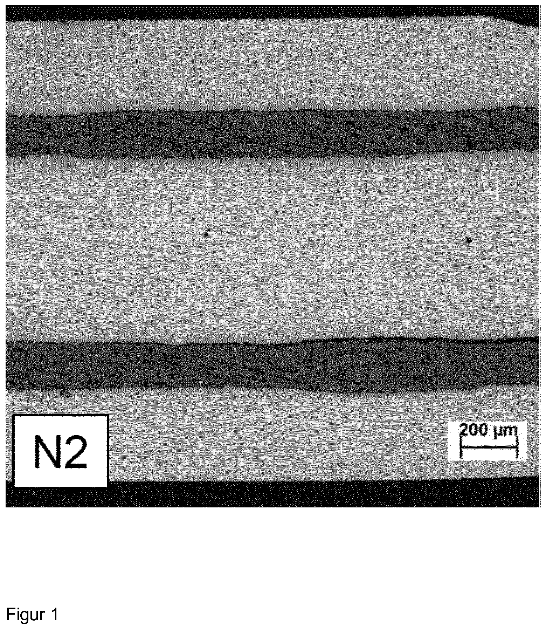

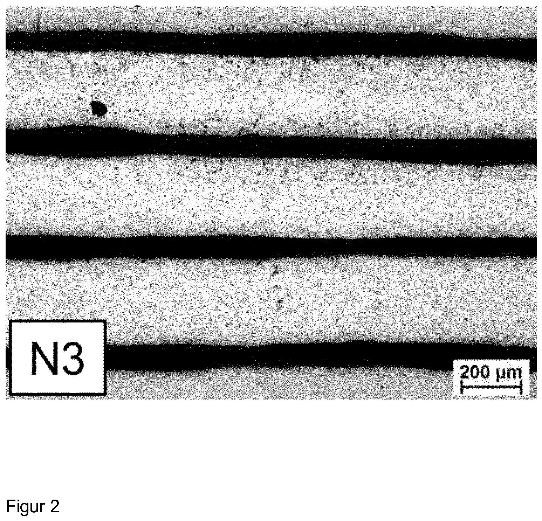

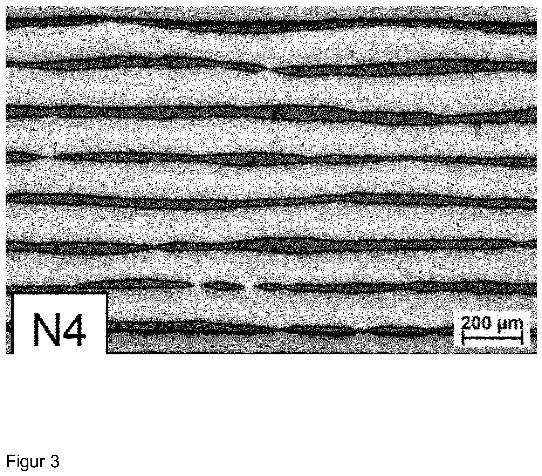

Die Figur 1 zeigt eine Aufnahme mit einem Raster-Elektronen-Mikroskop (REM) eines Querschliffs durch einen zweifach gefalteten kaltgewalzten Ag-Nb-Schichtverbund (N2) als Zwischenprodukt bei der Herstellung einer erfindungsgemäßen Folie. In den Figuren 2 bis 6 sind dreifach gefaltete Ag-Nb-Schichtverbunde (N3), vierfach gefaltete Ag-Nb-Schichtverbunde (N4), fünffach gefaltete Ag-Nb-Schichtverbunde (N5), sechsfach gefaltete Ag-Nb-Schichtverbunde (N6) und siebenfach gefaltete Ag-Nb-Schichtverbunde (N7) als Querschliffe gezeigt.

In den Aufnahmen sind die Ag-Schichten dunkel und die Nb-Schichten hell. Die Folien haben einen Anteil von 19 Gew% Nb und dem Rest Silber, einschließlich üblicher Verunreinigungen.

Zur Herstellung der erfindungsgemäßen Folie und die Schichtverbunde werden zunächst ein Ag-Nb-Schichtverbund durch Kaltwalzen aus zwei 2 mm dicken Silber-Blechen und einem 1 mm dickem Niob-Blech gefertigt. Die Silber-Bleche und das Niob-Blech wurden im Lieferzustand gewalzt. Die Silber-Bleche bestehen aus Feinsilber mit einer Reinheit von 99,9% (3N). Das Niob-Blech besteht aus Niob mit der Werkstoffbezeichnung "R04200 type 1" und hat einen Nb-Gehalt von mindestens 99,8% mit bis zu 0,1% Ta und wurde von der Firma WHS Sondermetalle e.K. geliefert.

Durch mehrfaches Falten durch Trennen des Schichtverbunds, Aufeinanderlegen der getrennten Teile des Schichtverbunds und durch Kaltwalzen der aufeinander angeordneten Teile des Schichtverbunds, werden immer mehr Ag-Schichten und Nb-Schichten in dem Schichtverbund erzeugt. Das Kaltwalzen erfolgt bei Raumtemperatur mit einer Walze von Carl Wezel BW 300/350 und bei einer Walzgeschwindigkeit von 8 m/min.

Die Herstellung der Schichtverbunde erfolgt mit einem ARB-Verfahren, so wie es in T. Nizolek et. al.: "Processing and Deformation Behavior of Bulk Cu-Nb Nanolaminates", Metallogr. Microstruct. Anal. (2014) 3, 470-476 beschrieben ist. Bei der Herstellung der Schichtverbunde werden ARB-Zyklenzahlen von N2 (zweifach gefaltet), N3 (dreifach gefaltet), N4 (vierfach gefaltet), N5 (fünffach gefaltet), N6 (sechsfach gefaltet) und N7 (siebenfach gefaltet) verwendet. Während des ARB-Verfahrens erfolgte eine Stichabnahme von jeweils 50-60 %. Zur Herstellung der Folien können diese ca. zwischen 0,5 mm und 1 mm dicken Schichtverbunde anschließend durch Kaltwalzen auf eine Dicke von etwa 42 µm gewalzt werden. Gegebenenfalls muss zwischen den Kaltwalzschritten eine Wärmebehandlung erfolgen, um das Umformvermögen des Schichtverbunds zu erhalten.

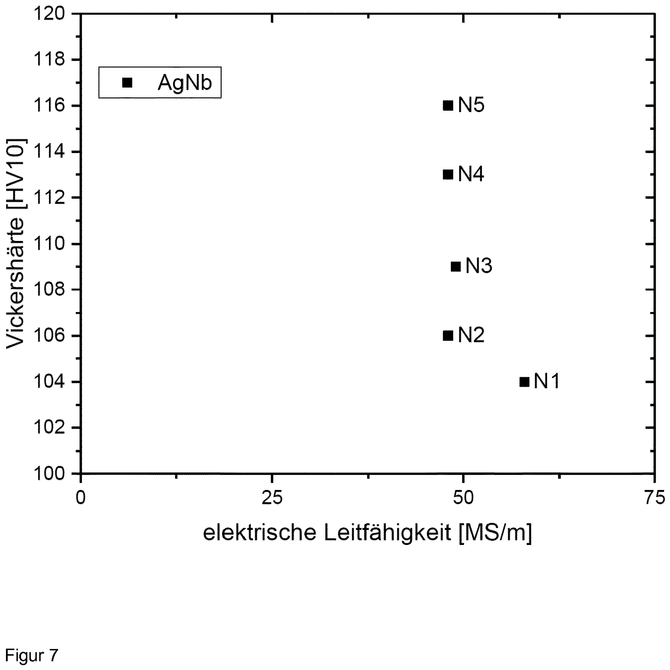

Zur Untersuchung erfolgt eine Charakterisierung der Lagenarchitektur und Mikrostruktur mit Hilfe von Rasterelektronenmikroskopie. Hierzu werden die Schichtverbunde als Zwischenprodukt in einer Richtung parallel zur Dicke der Schichtverbunde geschliffen. Der Kontrast im REM entsteht durch Rückstreuelektronen, so dass das Niob in den Figuren 1 bis 6 heller erscheint als das Silber. Ferner erfolgten eine Vickers-Härtemessung der Schichtverbunde in einer Richtung senkrecht zur Schichtverbundebene und eine Messung der elektrischen Leitfähigkeit in einer Richtung senkrecht zur Dicke der Folie. Die Ergebnisse hierzu sind in Figur 7 dargestellt.

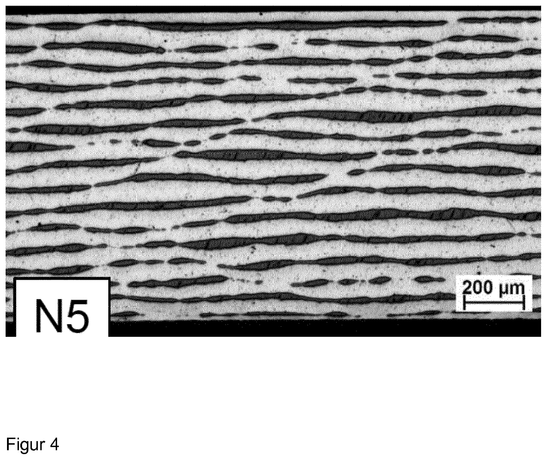

In den Figuren 4, 5 und 6 ist zu erkennen, dass die Nb-Schichten im Gegensatz zu den Nb-Schichten nach Figur 1 nicht mehr als gleichmäßig dicke Schichten in dem Schichtverbund vorliegen. Stattdessen ist bei den Faltungen und dem Kaltwalzen eine Schichtstruktur mit lokalisierten Nb-Einschlüssen entstanden, um die herum die Ag-Schichten angeordnet sind. Durch die von den Nb-Einschlüssen verursachten Verformungen der Ag-Schichten und durch die Nb-Einschlüsse selbst kommt es auch zu einer Verfestigung des Schichtverbunds aufgrund von Behinderungen der Versetzungsausbreitung in dem Material. Gleichzeitig kommen die Silber-Schichten an verschiedenen Stellen im Schichtverbund miteinander in Kontakt, so dass die elektrische Leitfähigkeit maßgeblich durch das Silber bestimmt wird. Eine vollständige Auftrennung der Nb-Schichten ist jedoch nicht erwünscht, da der Härtungseffekt bei noch vorhandener Schichtstruktur größer ist.

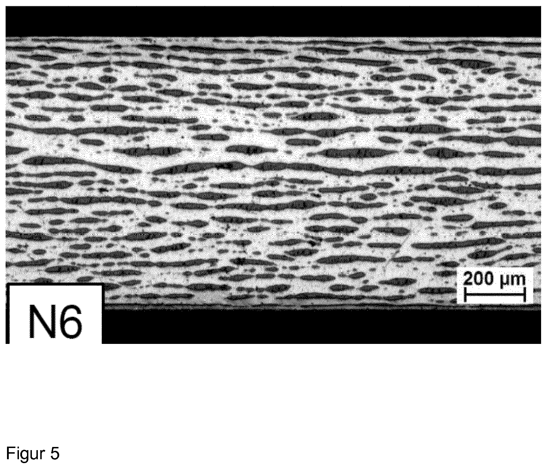

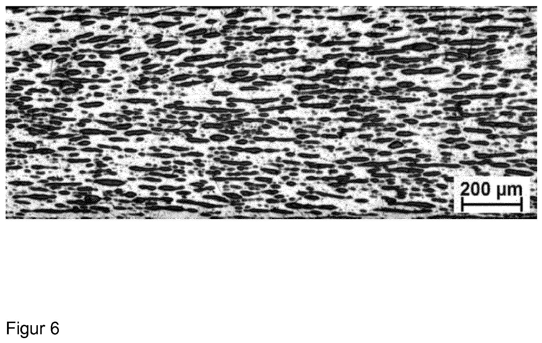

In den Figuren 4 bis 6 ist zu erkennen, dass sich lokale Nb-Einschlüsse im Schichtverbund bilden (siehe vor allem Figuren 5 und 6). Dennoch bleibt die Schichtstruktur in der Folie erhalten. Die Nb-Schichten sind teilweise nur noch etwa 10 $\mu$m dick (siehe Figur 6).

Wie in Figur 7 zu erkennen ist, ergibt sich für jede Faltung bis zur fünften Faltung (N5 - Figur 4) eine größere Vickers-Härte HV10 als bei reinem Silber (98) und bei reinem Niob (75) sowie eine ansteigende Vickers-Härte, bei nur geringfügig verringerter elektrischer Leitfähigkeit im Vergleich zu reinem Silber (61,36 * 10$^6$ A/(V m). Bei darüber hinausgehenden Faltungen ergeben sich keine weiteren Verbesserungen der Vickers-Härte HV10. So wurde für eine sechsfache Faltung (N6) eine Vickers-Härte HV10 von 115 und für eine siebenfache Faltung (N7) eine Vickers-Härte HV10 von 113.

Die Vickers-Härte HV10 wird für die in Figur 7 gezeigten Messwerte mit einer Kraft von 10 N in Richtung der Dicke der Folie gemessen. Die Messung der Vickers-Härte erfolgt gemäß DIN EN ISO 6507-1:2018 bis -4:2018: DIN Deutsches Institut für Normung e.V.: Metallische Werkstoffe- Härteprüfung nach Vickers-Teil 1: Prüfverfahren. Es handelt sich um eine Vickers-Mikrohärteprüfung.

Die elektrische Leitfähigkeit wird bestimmt durch eine Vierpunkt-Messmethode.

Die erfindungsgemäßen Schichtverbunde N3 und besonders N4 und N5 aber auch N6 und N7 zeichnen sich durch eine hohe Härte bei gleichzeitig guter elektrischer Leitfähigkeit aus. Die aus den Schichtverbunden kaltgewalzten Folien weisen dann ebenfalls eine größere Härte auf als die reinen Metalle Ag und Nb.

Die Folien mit ca. 42 $\mu$m Dicke so dünn, dass aus den so gefertigten Folien unmittelbar Prüfnadeln oder Bonddrähte durch Ausschneiden aus den Folien gewonnen werden können. Durch die dünnen Ag-Schichten und Nb-Schichten ergibt sich aber dennoch ein über den Querschnitt der Folie weitgehend homogenes Material. Die aus den Folien gefertigten Prüfnadeln nutzen sich aufgrund ihrer Härte nur langsam ab und leiten gleichzeitig den elektrischen Strom zum Prüfen einer Kontaktierung gut, so dass eine große Anzahl von elektrischen Kontakten bei hoher Empfindlichkeit der Messung geprüft werden kann, bevor die Prüfnadeln ausgetauscht werden müssen. Für die Bonddrähte oder Bondbändchen aus den erfindungsgemäßen Folien gilt, dass diese nur geringe Widerstandsverluste verursachen und gleichzeitig auch bei geringen Querschnitten einer mechanischen Belastung standhalten können. So kommt es bei einer guten elektrischen Kontaktierung zu geringen Ausschüssen bei der elektrischen Kontaktierung von Chips. Die Prüfnadeln oder Bonddrähte können zur Oberflächenvergütung mit einem oxidationsbeständigen Metall beschichtet werden. Hierzu kann beispielsweise Gold, Platin oder Palladium verwendet werden.

Die in der voranstehenden Beschreibung sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

**Patentansprüche**

1. Folie zur Herstellung von Prüfnadeln oder Bonddrähten, die Folie aufweisend eine Dicke von maximal 100 $\mu$m und die Folie aufweisend einen Schichtverbund aus
   Ag-Schichten aus Silber und/oder einer Silber-Basis-Legierung mit zumindest 90 Gew% Silber und Refraktärmetall-Schichten aus einem Refraktärmetall der Gruppe Niob und Tantal oder Refraktärmetall-Schichten aus einer Refraktärmetall-Basis-Legierung mit zumindest 90 Gew% zumindest eines Refraktärmetalls aus der Gruppe Niob, Tantal, Vanadium, Wolfram, Molybdän und Chrom.

2. Folie nach Anspruch 1, **dadurch gekennzeichnet, dass**
   der Schichtverbund zumindest 4 Ag-Schichten und 4 Refraktärmetall-Schichten pro 10 $\mu$m Dicke aufweist.

3. Folie nach Anspruch 1 oder 2, **dadurch gekennzeichnet, dass**
   die Refraktärmetall-Schichten Nb-Schichten sind, die aus Niob oder einer Nb-Basis-Legierung mit zumindest 90 Gew% Niob bestehen, oder
   die Refraktärmetall-Schichten Ta-Schichten sind, die aus Tantal oder einer Ta-Basis-Legierung mit zumindest 90 Gew% Tantal bestehen, oder
   die Refraktärmetall-Schichten NbTa-Schichten sind, die aus einer NbTa-Legierung mit zumindest 90 Gew% NbTa bestehen.

**4.** Folie nach einem der Ansprüche 1 bis 3, **dadurch gekennzeichnet, dass**
die Ag-Schichten in einer Richtung parallel zur Dicke der Folie miteinander verbunden sind, insbesondere kaltverschweißt sind, oder aneinander angrenzen, wobei vorzugsweise die Ag-Schichten eine zusammenhängende Matrix bilden, in der die Refraktärmetall-Schichten angeordnet sind, wobei besonders bevorzugt die Ag-Schichten auch in der Richtung parallel zur Dicke der Folie eine zusammenhängende Matrix bilden.

**5.** Folie nach einem der Ansprüche 1 bis 4, **dadurch gekennzeichnet, dass**
die Folie eine elektrische Leitfähigkeit von zumindest $10 * 10^6$ A/(V m) in einer Ebene senkrecht zur Dicke der Folie aufweist, bevorzugt eine elektrische Leitfähigkeit von zumindest $30 * 10^6$ A/(V m) in der Ebene senkrecht zur Dicke der Folie aufweist, besonders bevorzugt eine elektrische Leitfähigkeit von zumindest $40 * 10^6$ A/(V m) in der Ebene senkrecht zur Dicke der Folie aufweist.

**6.** Folie nach einem der Ansprüche 1 bis 5, **dadurch gekennzeichnet, dass**
der Schichtverbund als Zwischenprodukt zur Herstellung der Folie eine Vickers-Härte HV10 von zumindest 100 in einer Richtung senkrecht zur Schichtverbundebene aufweist, vorzugsweise eine Vickers-Härte HV10 von zumindest 110 in einer Richtung senkrecht zur Schichtverbundebene aufweist.

**7.** Folie nach einem der Ansprüche 1 bis 6, **dadurch gekennzeichnet, dass**
die maximalen Schichtdicken der Ag-Schichten und/oder die maximalen Schichtdicken der Refraktärmetall-Schichten kleiner als 5 $\mu$m sind, vorzugsweise kleiner als 1 $\mu$m sind.

**8.** Folie nach einem der Ansprüche 1 bis 7, **dadurch gekennzeichnet, dass**
der Anteil der Refraktärmetall-Schichten in dem gesamten Schichtverbund der Folie zwischen 3 Gew% und 30 Gew% liegt, bevorzugt zwischen 5 Gew% und 25 Gew%, besonders bevorzugt zwischen 15 Gew% und 20 Gew%.

**9.** Folie nach einem der Ansprüche 1 bis 8, **dadurch gekennzeichnet, dass**
die Ag-Schichten aus einer Silber-Basis-Legierung mit einem Kupfer-Gehalt zwischen 0,1 Gew% und 1 Gew% bestehen, vorzugsweise aus einer Silber-Basis-Legierung mit 0,4 Gew% Cu oder einer Silber-Basis-Legierung mit 0,8 Gew% Cu bestehen.

**10.** Folie nach einem der Ansprüche 1 bis 9, **dadurch gekennzeichnet, dass**
die Refraktärmetall-Schichten teilweise lokal begrenzte Einschlüsse zwischen den Ag-Schichten bilden,
wobei vorzugsweise die Einschlüsse sich in einer Breiten-Richtung senkrecht zur Dicke der Folie zwischen 10 $\mu$m und 1000 $\mu$m erstrecken und in einer Dicken-Richtung parallel zur Dicke der Folie zwischen 50 nm und 20 $\mu$m erstrecken und/oder
wobei vorzugsweise die Einschlüsse in der Breiten-Richtung senkrecht zur Dicke der Folie zumindest doppelt so groß sind, insbesondere zumindest fünfmal so groß sind, wie in der Dicken-Richtung parallel zur Dicke der Folie.

**11.** Folie nach einem der Ansprüche 1 bis 10, **dadurch gekennzeichnet, dass**
die Folie eine Dicke von mindestens 1 $\mu$m aufweist, bevorzugt eine Dicke von mindestens 5 $\mu$m aufweist, ganz besonders bevorzugt von zumindest 10 $\mu$m aufweist.

**12.** Verfahren zur Herstellung eines Schichtverbunds oder einer Folie zur Herstellung von Prüfnadeln oder Bonddrähten, **gekennzeichnet durch** die Schritte
Bereitstellen eines ersten Blechs aus Silber oder aus einer Silber-Basis-Legierung mit zumindest 90 Gew% Silber oder Bereitstellen zweier erster Bleche aus Silber und/oder aus einer Silber-Basis-Legierung mit zumindest 90 Gew% Silber,
Bereitstellen eines zweiten Blechs aus Niob oder aus einer Niob-Basis-Legierung mit zumindest 90 Gew% Niob oder aus Tantal oder aus einer Tantal-Basis-Legierung mit zumindest 90 Gew% Tantal oder aus einer Refraktärmetall-Legierung mit zumindest 90 Gew% zumindest eines Refraktärmetalls aus der Gruppe Niob, Tantal, Vanadium, Wolfram, Molybdän und Chrom; Übereinanderlegen des ersten Blechs und des zweiten Blechs oder Legen des zweiten Blechs zwischen die zwei ersten Bleche;
anschließendes Kaltwalzen des ersten Blechs und des zweiten Blechs oder der zwei ersten Bleche und des zweiten Blechs, so dass diese miteinander kaltverschweißen und einen Schichtverbund bilden; und Falten des Schichtverbunds durch Trennen des Schichtverbunds, Übereinanderlegen der Teile des Schichtverbunds und Kaltwalzen der übereinandergelegten Teile des Schichtverbunds oder durch Knicken des Schichtverbunds, Übereinanderlegen der abgeknickten Teile des Schichtverbunds und Kaltwalzen der übereinandergelegten Teile des Schichtverbunds, wobei das Falten zumindest dreimal wiederholt wird, um einen mehrfach gefalteten Schichtverbund zu erhalten.

**13.** Verfahren nach Anspruch 12, **dadurch gekennzeichnet, dass**
mit dem Verfahren eine Folie nach einem der Ansprüche 1 bis 11 hergestellt wird.

**14.** Verfahren nach Anspruch 12 oder 13, **dadurch gekennzeichnet, dass**

vor dem Übereinanderlegen des ersten Blechs und des zweiten Blechs zumindest die zum kaltverschweißen vorgesehenen Oberflächen des ersten Blechs und/oder des zweiten Blechs aufgeraut werden, insbesondere durch Bürsten aufgeraut werden, oder

vor dem Legen des zweiten Blechs zwischen die zwei ersten Bleche zumindest die zum kaltverschweißen vorgesehenen Oberflächen des ersten Blechs und/oder des zweiten Blechs aufgeraut werden, insbesondere durch Bürsten aufgeraut werden, wobei vorzugsweise alle zum kaltverschweißen vorgesehenen Oberflächen des ersten Blechs oder der zwei ersten Bleche und/oder des zweiten Blechs aufgeraut werden, besonders bevorzugt durch Bürsten mit einer Metallbürste aufgeraut werden.

**15.** Schichtverbund oder Folie erhältlich mit einem Verfahren nach einem der Ansprüche 12 bis 14.

**16.** Prüfnadel zur Messung einer elektrischen Kontaktierung hergestellt aus einer Folie nach einem der Ansprüche 1 bis 11 oder mit einem Verfahren nach einem der Ansprüche 12 bis 14, wobei die Prüfnadel eine Dicke zwischen 2 $\mu$m und 100 $\mu$m aufweist.

**17.** Bonddraht zur elektrischen Kontaktierung eines Chips hergestellt aus einer Folie nach einem der Ansprüche 1 bis 11 oder mit einem Verfahren nach einem der Ansprüche 12 bis 14, wobei der Bonddraht einen Querschnitt zwischen 2 $\mu$m und 100 $\mu$m aufweist.

Figur 1

EP 3 680 102 A1

Figur 2

12

Figur 3

Figur 4

Figur 5

Figur 6

Figur 7

| | Europäisches Patentamt<br>European Patent Office<br>Office européen des brevets | **EUROPÄISCHER RECHERCHENBERICHT** | **Nummer der Anmeldung**<br>EP 19 15 1347 |
|---|---|---|---|

## EINSCHLÄGIGE DOKUMENTE

| Kategorie | Kennzeichnung des Dokuments mit Angabe, soweit erforderlich,<br>der maßgeblichen Teile | Betrifft<br>Anspruch | KLASSIFIKATION DER<br>ANMELDUNG (IPC) |
|---|---|---|---|
| X | LAI W ET AL: "Observation of largely enhanced hardness in nanomultilayers of the Ag-Nb system with positive enthalpy of formation",<br>APPLIED PHYSICS LETTERS, A I P PUBLISHING LLC, US,<br>Bd. 90, Nr. 18, 2. Mai 2007 (2007-05-02), Seiten 181917-181917, XP012094491,<br>ISSN: 0003-6951, DOI: 10.1063/1.2735670<br>* Zusammenfassung *<br>* Seiten 181917-1, rechte Spalte, Absatz erster *<br>* Seiten 181917-2, rechte Spalte, letzter Absatz; Abbildung 4b *<br>* Abbildung 3 *<br>----- | 1-4,6,7,<br>10 | INV.<br>B32B15/01<br>B32B37/02<br>B32B38/00<br>G01R3/00<br>H01L23/00<br>B32B7/05 |
| X | WEI M Z ET AL: "The ultra-high enhancement of hardness and elastic modulus in Ag/Nb multilayers",<br>MATERIALS SCIENCE AND ENGINEERING: A,<br>Bd. 651, 10. Januar 2016 (2016-01-10), Seiten 155-159, XP029357241,<br>ISSN: 0921-5093, DOI:<br>10.1016/J.MSEA.2015.10.107<br>* Zusammenfassung *<br>* Seite 156, linke Spalte, Absatz erster *<br>* Abbildung 3 *<br>----- | 1-3,6,7,<br>11 | |
| | | | RECHERCHIERTE<br>SACHGEBIETE (IPC) |
| X | K KANODA ET AL: "Upper critical field of V-Ag multilayered superconductors",<br>PHYSICAL REVIEW B,<br>Bd. 35, Nr. 13, 1. Mai 1987 (1987-05-01), Seiten 6736-6748, XP055595445,<br>DOI:<br>https://doi.org/10.1103/PhysRevB.35.6736 | 1,2,5,7,<br>8,16,17 | B32B<br>G01R<br>H01L |
| Y | * Zusammenfassung *<br>* Tabelle 1 *<br>-----<br>-/-- | 9,12-15 | |

Der vorliegende Recherchenbericht wurde für alle Patentansprüche erstellt

| Recherchenort | Abschlußdatum der Recherche | Prüfer |
|---|---|---|
| Den Haag | 12. Juni 2019 | Rosciano, Fabio |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
...........................................................................
& : Mitglied der gleichen Patentfamilie, übereinstimmendes
    Dokument

EPO FORM 1503 03.82 (P04C03)

Seite 1 von 4

Europäisches
Patentamt

European
Patent Office

Office européen
des brevets

# EUROPÄISCHER RECHERCHENBERICHT

Nummer der Anmeldung

EP 19 15 1347

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | HONGXIU ZHANG ET AL: "Structure and Growth Mechanism of V/Ag Multilayers with Different Periodic Thickness Fabricated by Magnetron Sputtering Deposition", JOURNAL OF MATERIALS SCIENCE & TECHNOLOGY, Bd. 30, Nr. 10, 31. Januar 2014 (2014-01-31), Seiten 1012-1019, XP055595463, AMSTERDAM, NL ISSN: 1005-0302, DOI: 10.1016/j.jmst.2014.01.006 * Zusammenfassung * * 2. Experimental; Seite 1013 * * Seite 1013, rechte Spalte, Absatz zweiter; Abbildung 1a * * Abbildung 9 * ----- | 1,2,4,6, 7,10 | |
| X | Q. ZHOU ET AL: "Strain rate sensitivity and related plastic deformation mechanism transition in nanoscale Ag/W multilayers", THIN SOLID FILMS, Bd. 571, 26. März 2014 (2014-03-26), Seiten 253-259, XP055595189, AMSTERDAM, NL ISSN: 0040-6090, DOI: 10.1016/j.tsf.2014.03.061 * Zusammenfassung * * 2. Experimental procedures; Seite 254 * * 3.1 Microstructure; Seite 254; Abbildung 3 * * Tabelle 1 * ----- -/-- | 1,2,4,6, 7,10,11 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| Den Haag | 12. Juni 2019 | Rosciano, Fabio |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Seite 2 von 4

Europäisches
Patentamt

European
Patent Office

Office européen
des brevets

# EUROPÄISCHER RECHERCHENBERICHT

**Nummer der Anmeldung**

EP 19 15 1347

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | JIN O ET AL: "Unusual alloying behavior observed in the immiscible Ag@?Mo and Ag@?Nb systems under ion irradiation", NUCLEAR INSTRUMENTS & METHODS IN PHYSICS RESEARCH. SECTION B: BEAM INTERACTIONS WITH MATERIALS AND ATOMS, ELSEVIER BV, NL, Bd. 114, Nr. 1-2, 2. Juni 1996 (1996-06-02), Seiten 56-63, XP027302036, ISSN: 0168-583X [gefunden am 1996-06-02] * Zusammenfassung * * 3. Experimental procedure; Seite 58 * * Tabelle 2 * ----- | 1,2,7,8 | |
| Y | John Frick: "Engelhard Ag-Cu Alloys" In: "Woldman's Engineering Alloys", 1. Januar 2000 (2000-01-01), ASM International, XP055595761, ISBN: 978-0-87170-691-1 Seite 408, * Engelhard Alloy 15065, 16527 * ----- | 9 | |
| Y | GHALANDARI L ET AL: "High-strength and high-conductive Cu/Ag multilayer produced by ARB", JOURNAL OF ALLOYS AND COMPOUNDS, ELSEVIER SEQUOIA, LAUSANNE, CH, Bd. 506, Nr. 1, 10. September 2010 (2010-09-10), Seiten 172-178, XP027242850, ISSN: 0925-8388 [gefunden am 2010-07-07] * Zusammenfassung * * Abbildung 1 * ----- -/-- | 12-15 | RECHERCHIERTE SACHGEBIETE (IPC) |

Der vorliegende Recherchenbericht wurde für alle Patentansprüche erstellt

| Recherchenort | Abschlußdatum der Recherche | Prüfer |
|---|---|---|
| Den Haag | 12. Juni 2019 | Rosciano, Fabio |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

&  : Mitglied der gleichen Patentfamilie, übereinstimmendes
Dokument

EPO FORM 1503 03.82 (P04C03)

**Europäisches Patentamt**
**European Patent Office**
**Office européen des brevets**

# EUROPÄISCHER RECHERCHENBERICHT

Nummer der Anmeldung

EP 19 15 1347

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| T | MILLER M K ET AL: "Atom probe specimen preparation with a dual beam SEM/FIB miller", ULTRAMICROSCOPY, ELSEVIER, AMSTERDAM, NL, Bd. 107, Nr. 9, 1. September 2007 (2007-09-01), Seiten 761-766, XP025318904, ISSN: 0304-3991, DOI: 10.1016/J.ULTRAMIC.2007.02.023 [gefunden am 2007-05-25] * 2.2 Thin sheets * ----- | | |

**RECHERCHIERTE SACHGEBIETE (IPC)**

Der vorliegende Recherchenbericht wurde für alle Patentansprüche erstellt

| Recherchenort | Abschlußdatum der Recherche | Prüfer |
|---|---|---|
| Den Haag | 12. Juni 2019 | Rosciano, Fabio |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Seite 4 von 4

# EP 3 680 102 A1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 20140266278 A1
- US 20100194415 A1
- WO 2016009293 A1
- US 20130099813 A1
- EP 2060921 A1
- US 20120286816 A1

### In der Beschreibung aufgeführte Nicht-Patentliteratur

- **W. C. OLIVER ; G. M. PHARR.** *Journal of Materials Research,* 1992, 1564
- **J.M. WHEELER et al.** *Curr Opin Solid St M,* 2015, vol. 19, 354-366
- **T. NIZOLEK.** Processing and Deformation Behavior of Bulk Cu-Nb Nanolaminates. *Metallogr. Microstruct. Anal.,* 2014, vol. 3, 470-476